# EUROPEAN PATENT SPECIFICATION

(11) **EP 2 711 989 B1**
(45) Date of publication and mention of the grant of the patent: **06.11.2019**
(21) Application number: 13156375.1
(22) Date of filing: 22.02.2013
(51) Int. Cl.: H01L 31/0236

(54) **ETCHING COMPOSITION AND METHOD FOR ETCHING A SILICON WAFER**
ÄTZZUSAMMENSETZUNG UND VERFAHREN ZUM ÄTZEN EINES SILIZIUMWAFERS
COMPOSITION DE GRAVURE ET PROCÉDÉ PERMETTANT DE GRAVER UNE TRANCHE DE SILICIUM

(30) Priority: 20.09.2012 TW 101134424
(43) Date of publication of application: 26.03.2014
(73) Proprietor: Industrial Technology Research Institute, Hsinchu 31040 Taiwan (TW)
(72) Inventor: Yu, Sheng-Min, 31040 Hsinchu (TW); Sun, Wen-Ching, 31040 Hsinchu (TW); Wang, Tai-Jui, 31040 Hsinchu (TW); Chen, Yi-Fan, 31040 Hsinchu (TW); Sun, Chia-Liang, 31040 Hsinchu (TW); Chiang, Hao-Hsiang, 31040 Hsinchu (TW); Liao, Pin-Guan, 31040 Hsinchu (TW); Chiang, Chi-Fan, 31040 Hsinchu (TW); Lin, Tzer-Shen, 31040 Hsinchu (TW)
(74) Representative: Manitz Finsterwald Patent- und Rechtsanwaltspartnerschaft mbB

(56) References cited:
- KR-A- 20110 034 761
- US-A- 4 137 123
- US-A1- 2010 269 903
- US-A1- 2011 275 222

## Description

### BACKGROUND

### 1. Technical Field

This disclosure relates to etching compositions, and, more particularly, to an etching composition that forms a texture structure on a surface of a silicon wafer and a related method for etching a silicon wafer.

### 2. Description of Related Art

In order to solve the problems of environment pollution and power shortage, solar industry develops rapidly. A solar cell converts light into electricity.

In order to increase the conversion efficiency of a solar cell, a chip installed in the solar cell has to be controlled in an efficient manner. For example, the roughness of a front surface and the smoothness of a rear surface may affect the efficiency of the chip. In a passivated emitter and rear cell (PERC) and an interdigitated back contact (IBC) solar cell, a silicon chip, if having a texture structure formed on the front surface and a smooth rear surface, may increase the conversion efficiency of the cells.

In a conventional process of fabricating a solar cell, the rough front surface and the smooth rear surface of a chip are obtained by immersing the chip in an etching solution. The chip is first immersed in a roughness etching solution to form a roughness structure on both surfaces of the chip. Then, a protection cover is formed on one surface of the chip, and the chip is immersed in a smoothness etching solution. As a result, the chip has one surface roughed and the other surface smoothed. However, in the conventional process the chip is easily damaged or has a thickness reduced. Besides, the forming and removal of the protection cover increase the cost of the chip. US7,858,426 discloses a method of texturing solar cell and a method of manufacturing a solar cell by employing a batch-type wet etching process. Because the wet etching process is conducted on both surfaces of a chip, the chip is easily damaged and has a further reduced thickness.

US2003/0194309 relates to transporting rollers for transporting essentially flat articles, to holding-down means, and to a transporting system. A chip is guided by the transporting rollers and undergoes a sequence of wet etching. Although a texture structure is thus formed, the entire chip is still immersed in an etching solution and has thickness reduced on both surfaces thereof. Moreover, the chip thus fabricated has the roughness structure formed on both surfaces thereof, and does not meet the requirement for a high efficiency silicon solar cell. A smoothness process has to be performed on the chip additionally. Since immersed in the high temperature etching solution, the transporting rollers have to be coated with a Teflon layer, which increases the cost significantly.

US6,663,944 discloses a textured semiconductor wafer for a solar cell. In fabrication of the textured semiconductor wafer, a photoresist is sprayed, a baking process is performed to form a local covering mask on a single surface, and an immerse and etching process is then performed, to form a chip with one surface roughed and the other surface smoothed. However, the batch-type wet etching process still likely damages the chip, and the usage and removal of the photoresist increase the cost of the material and fabrication time.

US7,927,498 discloses a solar cell and a method of texturing a solar cell. The method includes applying a paste having metal particles onto a silicon chip by screen printing; heating the silicon chip to remove an organic solvent to form a metal mask; and immersing the silicon chip in an etching solution to form a single-surface reflective structure. However, the batch-typed wet etching immersion easily damages the chip, and the application and removal of the paste having the metal particles increase the material cost and production time.

US2005/0247674 discloses an etching media in the form of etching pastes for etching selected areas or the entire area of silicon surfaces and layers, by screen printing or pattern etching. However, such a paste-formed etching media is difficult to be removed, which results in the thinning of the chip and increases the possibility of breaking the silicon. Moreover, the use of the paste-formed etching media cannot form a high-quality textured and uniform structure.

US 2011/0275222 A1 relates to a texture formulation comprising an aliphatic diol, an alkaline compound, a carboxylic acid and water.

US2010/269903 A1, KR20110034761, US4137123 relate to compositions and methods of texturing silicon.

In summary, persons in the technical field eager for a novel etching method of fabricating a textured solar cell, in which only one surface is textured and etched, and the chip is not easily damaged during the etching process or has a reduced thickness.

### SUMMARY

The present disclosure provides an etching composition for a silicon wafer according to claim 1, and a method for etching a silicon wafer according to claim 3.

Through the use of the etching composition and the method, an excellent texture structure is provided on the surface of the silicon wafer. The etching composition and the method can also etch only a single surface of the silicon wafer, and there is no need to cover a protection mask on the other surface of the silicon wafer.

### BRIEF DESCRIPTION OF DRAWINGS

The disclosure can be more fully understood by reading the following detailed description of the preferred embodiments, with reference made to the accompanying drawings, wherein:
FIG. 1 is a flow chart of forming a texture surface of an embodiment according to the present disclosure;
FIG. 2 is a pattern of a single surface of a substrate that is self-foaming etched;
FIG. 3 depicts oxide separated from the single surface of the substrate;
FIG. 4 depicts a surface of a silicon chip etched by an etching composition of an embodiment according to the present disclosure;
FIG. 5 depicts a surface of a silicon chip etched by an etching composition of a comparative example according to the present disclosure;
FIG. 6 depicts a surface of a silicon chip etched by an etching composition of another comparative example according to the present disclosure;
FIG. 7 shows a relation between wavelength segments and the reflectivity of a foamed and etched silicon chip in an embodiment and in a comparative example; and
FIG. 8 shows a relation between wavelength segments and the reflectivity of a foamed and etched silicon chip in an embodiment and a batch-typed immersed and etched silicon chip in a comparative example.

### DETAILED DESCRIPTION

In the following detailed description, for purposes of explanation, numerous specific details are set forth in order to provide a through understanding of the disclosed embodiments. It will be apparent, however, that one or more embodiments may be practiced without these specific details. In other instances, well-known structures and devices are schematically shown in order to simplify the drawing.

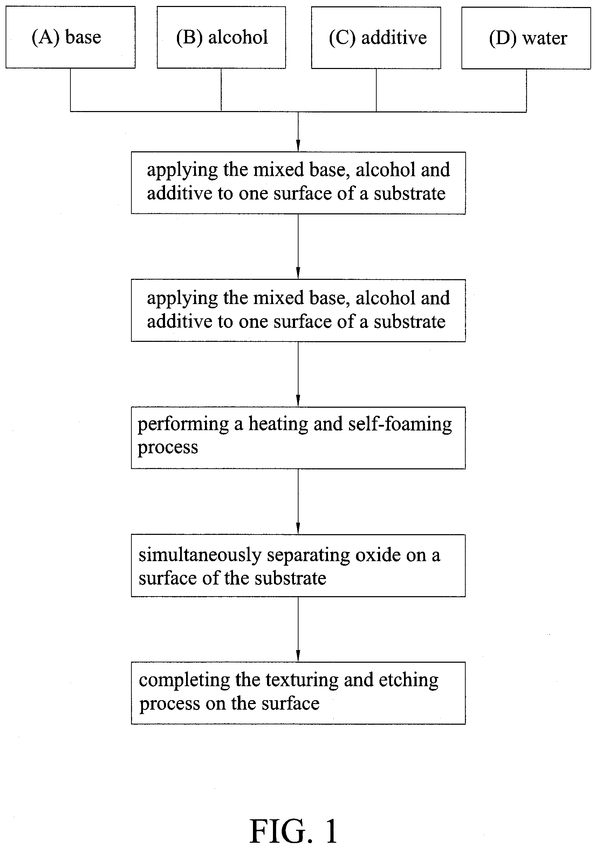

FIG. 1 is a flow chart of forming a texture surface of an embodiment according to the present disclosure. The method comprises: providing (A) base, (B) a specific alcohol, and (C) additive; oscillating and mixing the base, the alcohol and the additive by supersonic waves; applying the mixed base, alcohol and additive to one surface of a substrate; performing a heating and self-foaming process; simultaneously separating oxide on a surface of the substrate; and completing the texturing and etching process on the surface.

As shown in FIG. 1, an etching composition for a semiconductor comprises base, alcohol, and additive, wherein the etching composition reacts on the semiconductor wafer at an etching temperature to form a foam including a solid, a liquid and a gas that etches the semiconductor wafer.

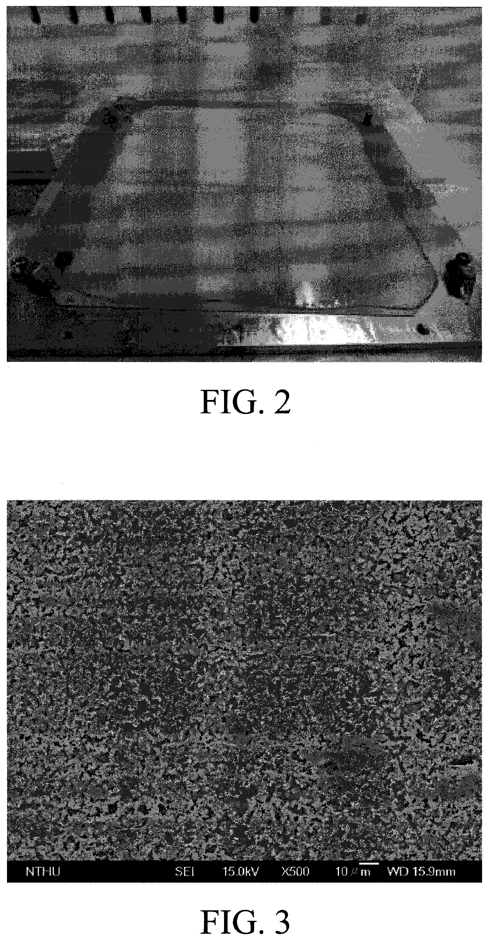

At an appropriate etching temperature, the etching composition forms the foam spontaneously, thereby forming on a surface of the silicon wafer a colloidal foam in which solid, liquid and gas co-exist in equilibrium, as shown in FIG. 2. The liquid of the etching composition can be maintained in the colloidal foam and prevented from flowing to a non-etching surface. In other words, the etching composition is easily controlled. Therefore, through the use of the etching composition according to the present disclosure the etching can be performed. According, it is not necessary to immerse the silicon wafer and the step of forming a protection cover on the non-etching surface is omitted. According to the present invention, the etching temperature ranges between 60°C and 200°C. In another embodiment, the etching temperature ranges between 80°C and 150°C.

In the etching process, the additive reacts on the silicon wafer to form oxide that covers the surface of the silicon wafer randomly, as shown in FIG. 3. Through the use of the etching composition, a texture structure can be formed on a surface of a silicon wafer to reduce the reflectivity. In an embodiment, the etching composition according to the present disclosure is used to form a silicon chip having a texture structure on a surface thereof, so as to fabricate a silicon chip solar cell having high conversion efficiency.

According to the invention, the base comprises at least one selected from the group consisting of potassium hydroxide and potassium carbonate. The alcohol comprises according to the invention at least one selected from the group consisting of ethylene glycol, diethylene glycol, glycerol, and triethylene glycol; and the additive comprises at least one selected from the group consisting of boric acid and potassium borate.

According to the invention, the etching composition comprises 0.5-50wt% base, 10-80wt% alcohol, and 0.01-15wt% additive.

According to the invention, the semiconductor wafer is made of silicon. In an embodiment, the semiconductor wafer is made of monocrystalline silicon, polycrystalline silicon or a combination thereof.

According to the invention, the etching composition comprises an additional component, namely water.

The method of etching a semiconductor wafer comprises: applying a first etching composition to a first surface of a silicon wafer; and etching the silicon wafer at an etching temperature of 60°C to 200°C, wherein the first etching composition comprises: (A) 0.5-50wt% base, which comprises at least one selected from the group consisting of potassium hydroxide and potassium carbonate; (B) 10-80wt% alcohol, wherein the alcohol comprises at least one selected from the group consisting of ethylene glycol, diethylene glycol, glycerol and triethylene glycol; (C) 0.01-15wt% additive, which comprises at least one selected from the group consisting of boric acid and potassium borate, and (D) water, wherein during etching the silicon wafer at an etching temperature of 60°C to 200°C, the first etching composition reacts on the silicon wafer to spontaneously form a foam that etches the silicon wafer and includes a solid, a liquid and a gas, and the additive reacts on the silicon wafer to form oxide that covers the surface of the silicon wafer randomly.

In another embodiment, the etching temperature ranges between 80°C and 150°C.

In a further embodiment, the method further comprises: applying a second etching composition to a second surface of the semiconductor wafer; and etching the semiconductor wafer at 60°C to 200°C, wherein the second etching composition comprises: 0.5-50wt% base; and 10-80wt% alcohol.
In an embodiment, the base of the first and second etching compositions comprises at least one selected from the group consisting of potassium hydroxide, and potassium carbonated, and the alcohol of the first and second etching compositions comprises at least one selected from the group consisting of ethylene glycol, diethylene glycol, glycerol, and triethylene glycol.

In an embodiment, the second etching composition comprises 0.5-50wt% base and 10-80wt% alcohol. In an embodiment, the semiconductor wafer is heated to the etching temperature before the application of the etching composition. In another embodiment, the semiconductor wafer is heated to the etching temperature after the application of the etching composition.

In an embodiment, the second etching composition comprises an additional component such as water.

The application of the first and second etching compositions can be performed by spray coating, spin coating, screen printing or a scraper.

The features and efficacy of the present disclosure are described according the specific embodiments, which, however, are not used to limit the scope of the present disclosure.

### <Embodiments>

### The preparation of the etching composition

Table 1 lists the components of the etching composition and their wt% in embodiments 1-8 and comparative examples 1-5. In embodiments 1-8, the etching composition prepared mainly comprises: 0.5-50wt% base; 10-80wt% alcohol; and 0.01-15wt% additive. In comparative examples 1-4, the etching composition prepared mainly comprises: 0.5-50wt% base; and 10-80wt% alcohol. In comparative example 5, the etching composition prepared mainly comprises: 1.5wt% potassium hydroxide; and 3wt% isopropyl alcohol.

**TABLE 1**

| | the components of the etching composition and their wt% | | | | | | |
|---|---|---|---|---|---|---|---|
| | base | alcohol | additive | Base (wt%) | alcohol (wt%) | Additive (wt%) | water (wt%) |
| embodiment 1 | potassium hydroxide | ethylene glycol | Boric acid | 10 | 80 | 5 | 5 |
| embodiment 2 | potassium hydroxide | diethylene glycol | Boric acid | 20 | 70 | 7.5 | 2.5 |
| embodiment 3 | potassium hydroxide | glycerol | Boric acid | 30 | 50 | 12 | 8 |
| embodiment 4 | potassium hydroxide | triethylene glycol | Boric acid | 20 | 60 | 10 | 10 |
| embodiment 5 | potassium carbonate | ethylene glycol | Boric acid | 15 | 80 | 1 | 4 |
| embodiment 6 | potassium carbonate | diethylene glycol | Boric acid | 20 | 70 | 0.75 | 9.25 |
| embodiment 7 | potassium carbonate | glycerol | Boric acid | 25 | 60 | 0.75 | 14.25 |
| embodiment 8 | potassium carbonate | triethylene glycol | Boric acid | 20 | 70 | 0.5 | 9.5 |
| Com. Ex. 1 | potassium carbonate | ethylene glycol | nil | 15 | 80 | - | 5 |
| Com. Ex. 2 | potassium carbonate | diethylene glycol | nil | 20 | 70 | - | 10 |
| Com. Ex. 3 | potassium carbonate | glycerol | nil | 25 | 60 | - | 15 |
| Com. Ex. 4 | potassium carbonate | triethylene glycol | nil | 20 | 70 | - | 10 |
| Com. Ex. 5 | potassium hydroxide | isopropyl alcohol | nil | 1.5 | 3 | - | 95.5 |

### Spontaneous foaming and etching

Twelve silicon chips are provided. The etching compositions in embodiments 1-8 and comparative examples 1-4 are applied to the surface of the twelve silicon chips by screen printing. Then, the silicon chips are heated to 120°C for eight minutes. Last, the etching composition is washed out. Therefore, the silicon chip has a textured surface.

### Batch-typed immerse etching

A silicon chip having a protection cover formed on a rear surface thereof is provided. The silicon chip is immersed in the etching composition in comparative example 5 that is heated to 80°C. The silicon chip is etched for 30 minutes. Then, the etching composition is washed out. Last, the protection cover is removed. Therefore, the silicon chip has a textured surface.

### Observing and evaluating the textured surface

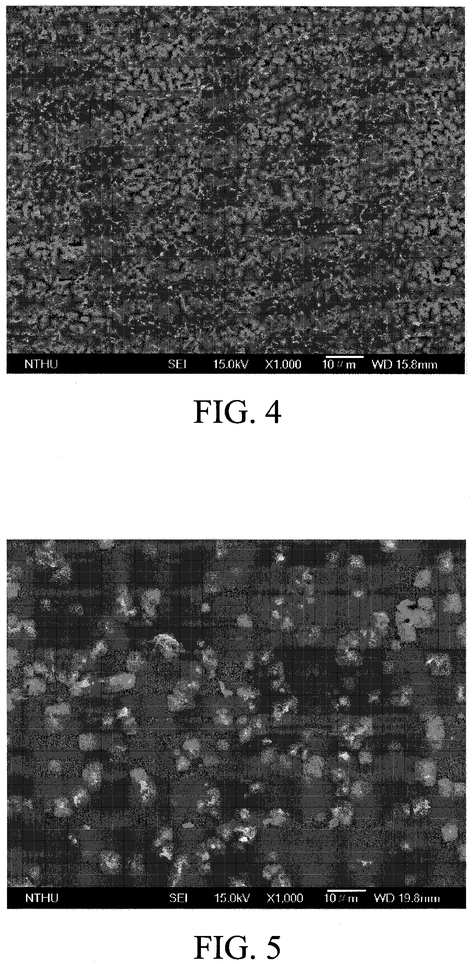

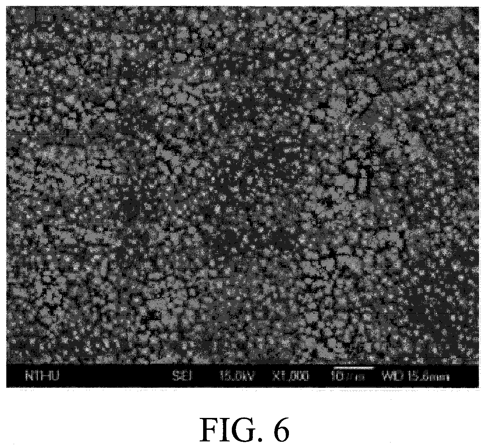

The textured surface of the silicon chip is observed by a scanning electron microscopy. As shown in FIG. 4, a plurality of dense pyramid structures, i.e., an excellent texture structure, are formed on the surface of the silicon chip. FIG. 5 shows the surface of the silicon chip etched by the etching composition in comparative example 3. It can be seen from FIG. 5 that the texture structure is not obvious. FIG. 6 shows the surface of the silicon chip etched by the etching composition of comparative example 5. It can be seen from FIG. 6 that the pyramid structure is dense, but it takes longer time to etch in comparative example 5. Besides, since the etching composition in comparative example 5 contains isopropyl alcohol that has a low boiling point, the etching composition consumes rapidly and needs to be refilled all the time, which increases the cost of the etching material and manufacturing equipment. Moreover, the batch-typed immerse etching makes the chip have rough structures on both surfaces thereof, which adversely affects the fabrication of a high-efficiency silicon chip solar cell.

As shown in Table 2, the standards for evaluating the textured process effect are as follows:
⊚ : excellent
○ : good
Δ : acceptable
× : poor

**TABLE 2**

| Etching composition | Etching manner | Textured process effect |
|---|---|---|
| Embodiment 1 | spontaneous foaming and etching | Δ |
| Embodiment 2 | spontaneous foaming and etching | ○ |
| Embodiment 3 | spontaneous foaming and etching | ⊚ |
| Embodiment 4 | spontaneous foaming and etching | ⊚ |
| Embodiment 5 | spontaneous foaming and etching | ○ |
| Embodiment 6 | spontaneous foaming and etching | ○ |
| Embodiment 7 | spontaneous foaming and etching | ⊚ |
| Embodiment 8 | spontaneous foaming and etching | ⊚ |
| Com. Ex. 1 | spontaneous foaming and etching | × |
| Com. Ex. 2 | spontaneous foaming and etching | × |
| Com. Ex. 3 | spontaneous foaming and etching | × |
| Com. Ex. 4 | spontaneous foaming and etching | × |
| Com. Ex. 5 | Batch-typed immerse etching | ⊚ |

### Measurement of reflectivity

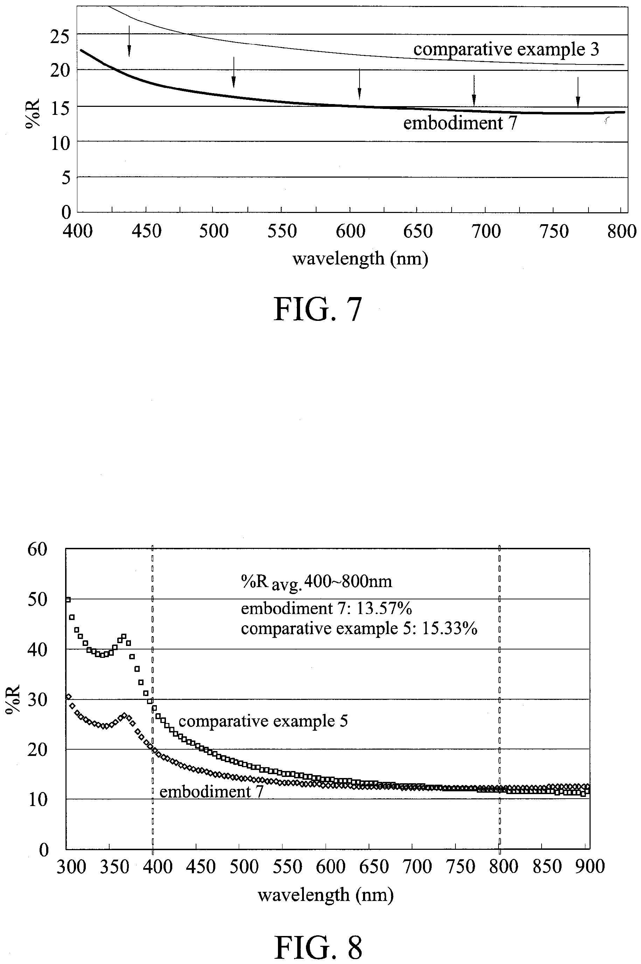

The reflectivity of the etched surface of the silicon chip is measured with JASCO V670 Research UV-Visible Spectrophotomer. FIG. 7 shows a relation between wavelength segments and the reflectivity of the foamed and etched silicon chip in embodiment 7 and comparative example 3. As shown in FIG. 7, the reflectivity of the silicon chip, after etched by the etching composition containing boric acid in embodiment, is low. In other words, the silicon chip has excellent anti-reflectivity. FIG. 8 shows a relation between wavelength segments and the reflectivity of the silicon chip in embodiment 7 and comparative example 5. As shown in FIG. 8, the reflectivity of the silicon chip, after etched by the etching composition containing boric acid in embodiment 7, is low. In other words, the silicon chip has excellent anti-reflectivity.

It will be apparent to those skilled in the art that various modifications and variations can be made to the disclosed embodiments. It is intended that the specification and examples be considered as exemplary only, with a true scope of the disclosure being indicated by the following claims.

## Claims

1. An etching composition for a silicon wafer, comprising:
(A) 0.5-50wt% base, which comprises at least one selected from the group consisting of potassium hydroxide and potassium carbonate;
(B) 10-80wt% alcohol, wherein the alcohol comprises at least one selected from the group consisting of ethylene glycol, diethylene glycol, glycerol and triethylene glycol;
(C) 0.01-15wt% additive, which comprises at least one selected from the group consisting of boric acid and potassium borate; and
(D) water,
wherein the etching composition is able to react on a silicon wafer at an etching temperature of 60°C to 200°C to spontaneously form a foam that etches the silicon wafer and includes a solid, a liquid and a gas, and the additive is able to react on the silicon wafer to form oxide that covers a surface of the silicon wafer randomly.

2. The etching composition of claim 1, wherein the silicon wafer is fabricated from monocrystalline silicon, polycrystalline silicon or a combination thereof.

3. A method for etching a silicon wafer, comprising:
applying a first etching composition to a first surface of a silicon wafer; and
etching the silicon wafer at an etching temperature of 60°C to 200°C,
wherein the first etching composition comprises:
(A) 0.5-50wt% base, which comprises at least one selected from the group consisting of potassium hydroxide and potassium carbonate;
(B) 10-80wt% alcohol, wherein the alcohol comprises at least one selected from the group consisting of ethylene glycol, diethylene glycol, glycerol and triethylene glycol;
(C) 0.01-15wt% additive, which comprises at least one selected from the group consisting of boric acid and potassium borate;
(D) water,
wherein during etching the silicon wafer at an etching temperature of 60°C to 200°C, the first etching composition reacts on the silicon wafer to spontaneously form a foam that etches the silicon wafer and includes a solid, a liquid and a gas, and the additive reacts on the silicon wafer to form oxide that covers the surface of the silicon wafer randomly.

4. The method of claim 3, wherein the silicon wafer is heated to the etching temperature after the first etching composition is applied to the first surface of the silicon wafer.

5. The method of claim 3, wherein applying the first etching composition is performed by spray coating, spin coating, screen printing or a scraper.

6. The method of claim 3, wherein the silicon wafer is fabricated from monocrystalline silicon, polycrystalline silicon or a combination thereof.

7. The method of claim 3, further comprising:
applying a second etching composition to a second surface of the silicon wafer; and
etching the silicon wafer at 60-200°C,
wherein the second etching composition comprising:
(A) 0.5-50wt% base;
(B) 10-80wt% alcohol; and
(C) optionally water.

## Patentansprüche

1. Ätzzusammensetzung für einen Siliciumwafer, umfassend:
(A) 0,5-50 Gewichtsprozent Base, welche zumindest eines umfasst, das ausgewählt ist aus der Gruppe bestehend aus Kaliumhydroxid und Kaliumcarbonat;
(B) 10-80 Gewichtsprozent Alkohol, wobei der Alkohol zumindest eines umfasst, das ausgewählt ist aus der Gruppe bestehend aus Ethylenglycol, Diethylenglycol, Glycerin und Triethylenglycol;
(C) 0,01-15 Gewichtsprozent Additiv, welches zumindest eines umfasst, das ausgewählt ist aus der Gruppe bestehend aus Borsäure und Kaliumborat; und
(D) Wasser,
wobei die Ätzzusammensetzung fähig ist, auf einem Siliciumwafer bei einer Ätztemperatur von 60 °C bis 200 °C zu reagieren, um spontan einen Schaum zu bilden, der den Siliciumwafer ätzt und einen Feststoff, eine Flüssigkeit und ein Gas enthält, und das Additiv fähig ist, auf dem Siliciumwafer zu reagieren, um Oxid zu bilden, das die Oberfläche des Siliciumwafers unregelmäßig bedeckt.

2. Ätzzusammensetzung nach Anspruch 1, wobei der Siliciumwafer hergestellt ist aus einkristallinem Silicium, polykristallinem Silicium oder einer Kombination derselben.

3. Verfahren zum Ätzen eines Siliciumwafers, umfassend:
Das Aufbringen einer ersten Ätzzusammensetzung auf eine erste Oberfläche eines Siliciumwafers; und das Ätzen des Siliciumwafers bei einer Ätztemperatur von 60 °C bis 200 °C, wobei die erste Ätzzusammensetzung umfasst:
(A) 0,5-50 Gewichtsprozent Base, welche zumindest eines umfasst, das ausgewählt ist aus der Gruppe bestehend aus Kaliumhydroxid und Kaliumcarbonat;
(B) 10-80 Gewichtsprozent Alkohol, wobei der Alkohol zumindest eines umfasst, das ausgewählt ist aus der Gruppe bestehend aus Ethylenglycol, Diethylenglycol, Glycerin und Triethylenglycol;
(C) 0,01-15 Gewichtsprozent Additiv, welches zumindest eines umfasst, das ausgewählt ist aus der Gruppe bestehend aus Borsäure und Kaliumborat; und
(D) Wasser,
wobei während des Ätzens des Siliciumwafers bei einer Ätztemperatur von 60 °C bis 200 °C die erste Ätzzusammensetzung auf dem Siliciumwafer reagiert, um spontan einen Schaum zu bilden, der den Siliciumwafer ätzt und einen Feststoff, eine Flüssigkeit und ein Gas enthält, und das Additiv auf dem Siliciumwafer reagiert, um Oxid zu bilden, das die Oberfläche des Siliciumwafers unregelmäßig bedeckt.

4. Verfahren nach Anspruch 3, wobei der Siliciumwafer auf die Ätztemperatur aufgeheizt wird, nachdem die erste Ätzzusammensetzung auf die erste Oberfläche des Siliciumwafers aufgebracht wird.

5. Verfahren nach Anspruch 3, wobei das Aufbringen der ersten Ätzzusammensetzung mittels Sprühbeschichtung, Rotationsbeschichtung, Siebdruck oder einer Rakel durchgeführt wird.

6. Verfahren nach Anspruch 3, wobei der Siliciumwafer hergestellt ist aus monokristallinem Silicium, polykristallinem Silicium oder einer Kombination derselben.

7. Verfahren nach Anspruch 3, zudem umfassend:
Das Aufbringen einer zweiten Ätzzusammensetzung auf eine zweite Oberfläche des Siliciumwafers; und das Ätzen des Siliciumwafers bei 60-200 °C, wobei die zweite Ätzzusammensetzung umfasst:
(A) 0,5-50 Gewichtsprozent Base;
(B) 10-80 Gewichtsprozent Alkohol; und
(C) optional Wasser.

## Revendications

1. Composition de gravure pour tranche de silicium, comprenant :
(A) 0,5 - 50 % en poids de base, qui comprend au moins un choisi dans le groupe constitué par l'hydroxyde de potassium et le carbonate de potassium ;
(B) 10 - 80 % en poids d'alcool, où l'alcool comprend au moins un choisi dans le groupe constitué par l'éthylène glycol, le diéthylène glycol, le glycérol et le triéthylène glycol ;
(C) 0,01 - 15 % en poids d'additif, qui comprend au moins un choisi dans le groupe constitué par l'acide borique et le borate de potassium ; et
(D) de l'eau,
laquelle composition de gravure étant capable de réagir sur une tranche de silicium à une température de gravure de 60 °C à 200 °C pour former spontanément une mousse qui grave la tranche de silicium et comprend un solide, un liquide et un gaz, et l'additif étant capable de réagir sur la tranche de silicium pour former un oxyde qui recouvre une surface de la tranche de silicium de manière aléatoire.

2. Composition de gravure selon la revendication 1, dans laquelle la tranche de silicium est fabriquée à partir de silicium monocristallin, de silicium polycristallin ou d'une de leurs combinaisons.

3. Procédé pour graver une tranche de silicium, comprenant les étapes consistant à :
appliquer une première composition de gravure à une première surface d'une tranche de silicium ; et
graver la tranche de silicium à une température de gravure de 60 °C à 200 °C,
dans laquelle la première composition de gravure comprend :
(A) 0,5 - 50 % en poids de base, qui comprend au moins un choisi dans le groupe constitué par l'hydroxyde de potassium et le carbonate de potassium ;
(B) 10 - 80 % en poids d'alcool, où l'alcool comprend au moins un choisi dans le groupe constitué par l'éthylène glycol, le diéthylène glycol, le glycérol et le triéthylène glycol ;
(C) 0,01 - 15 % en poids d'additif, qui comprend au moins un choisi dans le groupe constitué par l'acide borique et le borate de potassium ; et
(D) de l'eau,
dans lequel durant la gravure de la tranche de silicium à une température de gravure de 60 °C à 200 °C, la première composition de gravure réagit sur la tranche de silicium pour former spontanément une mousse qui grave la tranche de silicium et comprend un solide, un liquide et un gaz, et l'additif réagit sur la tranche de silicium pour former un oxyde qui recouvre la surface de la tranche de silicium de manière aléatoire.

4. Procédé selon la revendication 3, dans lequel la tranche de silicium est chauffée à la température de gravure après que la première composition de gravure est appliquée à la première surface de la tranche de silicium.

5. Procédé selon la revendication 3, dans lequel la première composition de gravure est effectuée par revêtement par pulvérisation, revêtement par centrifugation, impression d'écran ou un racleur.

6. Procédé selon la revendication 3, dans lequel la tranche de silicium est fabriquée à partir de silicium monocristallin, de silicium polycristallin ou d'une de leurs combinaisons.

7. Procédé selon la revendication 3, comprenant en outre les étapes consistant à :
appliquer une seconde composition de gravure à une seconde surface de la tranche de silicium ; et
graver la tranche de silicium à 60 - 200 °C,
dans lequel la seconde composition de gravure comprenant :
(A) 0,5 - 50 % en poids de base ;
(B) 10 - 80 % en poids d'alcool ; et
(C) éventuellement de l'eau.
